Europäisches Patentamt

European Patent Office

Office européen des brevets

(19)

(11) Publication number: **0 056 737**

**A2**

(12) **EUROPEAN PATENT APPLICATION**

(21) Application number: **82300288.6**

(22) Date of filing: **20.01.82**

(51) Int. Cl.³: **H 01 L 21/203**

(30) Priority: **21.01.81 JP 6395/81**

(43) Date of publication of application:
**28.07.82 Bulletin 82/30**

(84) Designated Contracting States:
**DE FR GB NL**

(71) Applicant: **Hitachi, Ltd.
5-1, Marunouchi 1-chome
Chiyoda-ku Tokyo 100(JP)**

(72) Inventor: **Shiraki, Yasuhiro
3-26-1, Hirayama
Hino-shi Tokyo(JP)**

(72) Inventor: **Matsui, Makoto
2-14-10, Kita
Kunitachi-shi Tokyo(JP)**

(72) Inventor: **Kobayashi, Keisuke L I
4-3-13-109, Nishi-ikuta Tama-ku
Kawasaki-shi Kanagawa-ken(JP)**

(72) Inventor: **Murayama, Yoshimasa
4-2-1-320, Maehara-cho
Koganei-shi Tokyo(JP)**

(74) Representative: **Jackson, John Timothy et al,
MEWBURN ELLIS & CO. 2/3 Cursitor Street
London EC4A 1BQ(GB)**

(54) **Method of manufacturing a semiconductor device using molecular beam epitaxy.**

(57) In a molecular beam epitaxy process, a semiconductor layer is evaporated onto a substrate (13) in a vacuum vessel (11) under ultra-high vacuum, from a first evaporation source (124). Subsequently, an insulator layer and a metal layer are evaporated onto the semiconductor layer from further sources (12, 12', 12'', 121). To prevent the formation of surface states in the interface between the layers, which might adversely affect the mobility of carriers in a MOSFET subsequently formed, these subsequent layers are formed without removing the substrate from the vacuum.

*FIG. 1*

## METHOD OF MANUFACTURING A SEMICONDUCTOR DEVICE

This invention relates to a method of manufacturing a semiconductor device employing evaporation under ultra-high vacuum (usually called "molecular-beam epitaxy process" - abbreviated to MBE process).

In recent years, the technique has progressed in which semiconductor films are formed on a crystal substrate, or alternatively on an amorphous substrate of glass or the like or a polycrystalline substrate, using the MBE process. Semiconductor devices employing the semiconductor films have been developed.

With this technique, however, there has been the difficulty that when such semiconductor layer formed under an ultra-high vacuum subsequently has, e.g. an insulator layer formed thereon under conditions other than ultra-high vacuum, a surface state appears in the interface between the semiconductor layer and the insulator layer on account of, e.g. an impurity taken into the insulator layer, so the mobility of the carriers is lowered.

Further, a similar difficulty is involved when forming a metal film on an insulator layer.

Molecular beam epitaxy has been reported in detail in, for example, "Progress in Solid-State Chemistry", Vol. 10, Part 3, pp. 157-191, Pergamon Press 1975.

In reports made up to now, the advantage of the MBE process has not been fully exploited as described above.

The present invention provides a method of manufacturing a semiconductor device, including the step of evacuating a vacuum vessel to an ultra-high vacuum, the vessel containing a first evaporation source and a substrate having a surface onto which a layer is to be evaporated; and the step of forming a first evaporation layer on said surface using the first evaporation source; characterised in that the vacuum vessel contains at least a second evaporation source, and the method includes the step of subsequently forming a second evaporation layer on the first evaporation layer, using the second evaporation source, without removing the substrate from the vacuum vessel between the formation of the first and second evaporation layers.

One of the evaporation sources can be a semiconductor material and another an insulator material. Suitably the pressure of the vacuum is at most $10^{-9}$ Torr. Of course, further substances can be evaporated into multilayer films as may be needed.

By employing a glass substrate, a ceramic substrate or the like as the aforecited substrate, a large area is readily attained. When employing a single-crystal substrate, the size of the semiconductor device is limited first by the size of the substrate. A silicon substrate is limited to a size of approximately 75 mm x 75 mm.

Since the present invention, at least in the preferred example, forms multilayer films consecutively within the same vessel, the films do not touch the outside air containing many contamination sources, and hence, not only the formed films themselves but also the interfaces of the respective films are kept clean. For this reason, the multilayer films obtained are free from the occurrence of a surface state, are very stable without fluctuations and exhibit good characteristics. More specifically, it is a matter of course that when adsorbed in a film to be formed, residual gases such as the air degrade the characteristics of the film. Even when a film has been formed clean, once the film is exposed to the outside air or the like, various kinds of molecules contained in the atmosphere adhere to the surface thereof. When a further film is formed with the molecules left adherent, these molecules degrade the respective films directly or indirectly. When the multilayer films which have been formed bearing the impure molecules etc. in this manner are used in a device, they have evil effects on the electrical characteristics of the device such as the threshold voltage and the breakdown voltage or on the design and control of the device. With our preferred multilayer films, factors allowing such degradation are fully eliminated, and good multilayer films can be formed without any such problems.

Such multilayer films are very effective when utilised for the formation of a semiconductor device, especially a semiconductor element sensitive to the surface state, such as MOSFET (MOS type Field Effect Transistor).

Owing to the interaction between a semiconductor (e.g. Si) molecular beam which comes flying within the ultra-high vacuum, and the surface of a glass substrate, adsorbed Si molecules grow as an Si film of high purity which imbibes residual gases little. By virtue of the clean atmosphere of the ultra-high vacuum, the silicon which has reached the surface of the glass substrate has its thermal motion hindered little by foreign molecules (residual gases etc.). Accordingly, it becomes a thermodynamically stable crystal phase even at a low temperature. Where the atmosphere of the vacuum vessel exceeds $10^{-9}$ Torr, its reactions with the residual gases become intense to rapidly lower the purity of the film and to hinder the thermal motion of the silicon on the substrate, so that the crystallisation becomes difficult. In the case of an ultra-high vacuum whose pressure is at most $10^{-9}$ Torr, the mean free path is several km to several hundred km, and the scattering molecules are not hindered by the foreign residual gas molecules or impurity atoms, so that they are grown on the glass as a crystal. In addition, where the substrate is below room temperature, kinetic energy required for the crystallisation is insufficient, and the growth of a crystal film of good quality is not attained. Where the softening point of the substrate glass is exceeded, the substrate is melted or transformed, so that the crystal film is not grown.

The glass substrate is not a crystalline body, but it is usually a non-crystalline body (amorphous or vitreous). In the ultra-high vacuum atmosphere, however, the film to be formed on the glass substrate has the property of becoming a crystal layer as stated before.

The degree of vacuum during the evaporation is suitably below $1 \times 10^{-8}$ Torr in terms of pressure, and the partial pressure of oxygen is below $1 \times 10^{-9}$ Torr.

On the semiconductor film formed, an insulating film is formed within the aforecited ultra-high vacuum. Since the insulating film is ordinarily a compound such as $SiO_2$, $Si_3N_4$ and $Al_2O_3$, a method of evaporation as described below may be adopted. For example, in case of $Al_2O_3$, an Al molecular beam is generated from a cell disposed by the side of a vaporisation source for Si and is let fly onto the Si film in an oxygen atmosphere. In general, in order to facilitate the formation of $Al_2O_3$, the Si film has light or an electron beam directed thereon or is irradiated with nascent oxygen. Where the evaporation source is of low melting point, the molecular beam-generating vessel may well be a vessel in the shape of a crucible round which a resistive heater is wound. In the case of a high melting point, a vessel which is capable of electron-beam heating, induction heating or the like is used. When the evaporation film is to be varied, a shutter or the like is adjusted, whereby the insulating film can be readily formed on the semiconductor film.

Where a metal film is to be formed on the semiconductor film, it is quite similarly formed within the aforecited ultra-high vacuum. A metal element of high melting point such as Mo, Ta, Pd, Pt, W and Ti is evaporated by putting it into a metal molecular beam likewise to the case of the semiconductor. In the case of a metal compound, it is important to independently evaporate the constituents of the compound from individual cells as in the case of the insulating film. This is because the vapor pressures of the respective elements constituting the compound are unequal.

In this manner, the present invention preferably consists in evaporating films by irradiating a substrate at a low temperature with the molecular beam of the respective evaporation sources within ultra-high vacuum. Therefore, even when the evaporation sources include materials of quite different natures such as a semiconductor, insulator and metal, the films can be continuously and successively grown without possessing any foreign molecule or residual gas exerting an adverse effect, in the interfaces and the materials. Various means can be used to generate the molecular beam, including the foregoing methods using an electron beam and r. f. heating, and methods using a laser beam or a plasma exhibit quite similar effects.

An example of the method of this invention will now be described in detail, with reference to the accompanying drawings, wherein:

Figure 1 is a view for explaining the outline of an ultra-high vacuum evaporation apparatus, and

Figures 2a to 2h are partial sectional views showing the manufacturing steps of a semiconductor device.

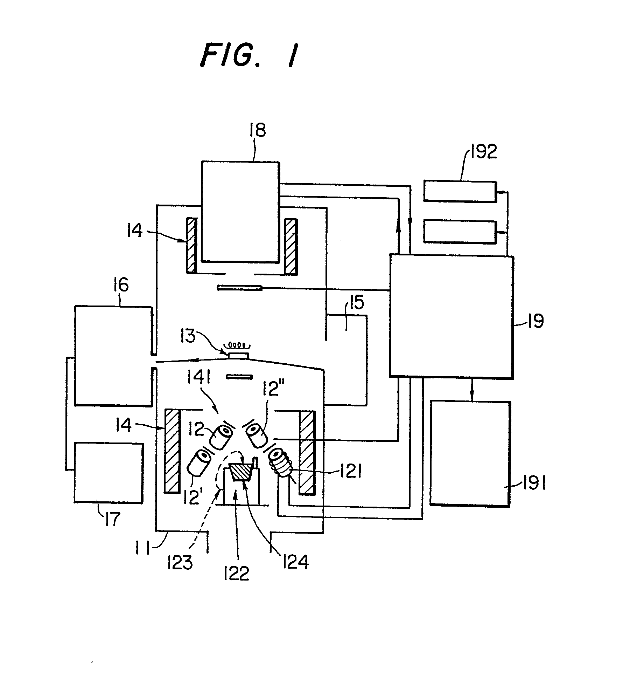

As illustrated in Figure 1, a vacuum vessel 11 is held under an ultra-high vacuum condition with a pressure of at most $10^{-9}$ Torr. The fore end part (surface part) of a Si source 124 is held in a melted state by an electron beam 123 emitted from an E (Electron) gun-system 122, and a molecular beam of Si is generated. The electron beam 123 is deflected by an external magnetic field so as to collide against the Si source 124. With the molecular beam, an Si film can be epitaxially grown on a glass substrate 13 at a rate of 1 - 100 Å/second. The Si grows up on the substrate 13 to a film thickness of 500 Å to several μm under a polycrystalline state. Subsequently, an insulating film is formed on the Si film. In the case of depositing, for example, an oxide film as the insulating film, a vaporization source 12 is used to form a molecular beam of $SiO_2$ by way of example so as to deposit the $SiO_2$ on the polycrystalline film. The vaporised $SiO_2$ molecules reach the glass substrate 13 through an aperture 141 which is provided in a shroud 14. Vaporisation sources 12',12" and 121 are used as are needed for the compositions of films to be formed.

By adopting the above MBE process, several advantages can be achieved. It is possible to obtain various information whilst forming a thin film and to feed it back to control the growth of the film. First, the clean state of the substrate 13 before the growth or the surface structure of the grown layer can be immediately known by the use of an RHEED (Reflection High Energy Electron Diffraction) device which consists of an electron gun 15 and a fluorescent screen 16 as well as a controller 17 thereof, these being mounted on predetermined positions of the vacuum vessel 11. In addition, a mass spectrometer 18 which is placed in opposition to the vaporisation source 12 or 124 (and if necessary, to the sources 12',12" and 121) measures the kinds and quantities of residual gases and the quantities of respective constituent elements given forth from the vaporisation sources 12,124 etc. This information is inputted to a computer 19 for process control. The growth rate, the thickness of the film, the composition ratio of a mixed crystal and the impurity concentration which have been calculated by the computer are immediately displayed on a cathode-ray tube 191 and plotted on a recorder 192. Simultaneously therewith, they are fed back to the temperature control of a molecular-beam generator vessel (vaporization source oven). In the illustrated example, the vaporization source 121 is connected to the computer controller 19. The crystal growth is entirely programmed, and films of a multilayer structure are formed. In the vapor growth or liquid growth which is presently used as the epitaxial growth process of semiconductor films, only the temperature is obtained as an information during the crystal growth. In this connection, it is possible to say that MBE is a film growing method which is really rich in controllability. Regarding the epitaxial growth of a compound semiconductor such as GaAs, since the vapor pressures of the constituent elements are remarkably different, obtaining of the compound at the stoichiometric ratio is difficult merely by vaporising a GaAs bulk or the like material as it is. In this regard, a compound at the predetermined stoichiometric ratio is obtained by the so-called three-temperature method in which the elements of the composition are vaporised from individual vaporisation sources and in which the component of the higher vapor pressure is supplied in excess. Also in this case, since the interior of the evaporation chamber is under ultra-high vacuum, a crystal at the stoichiometric ratio can be grown merely by causing the beams of the constituent elements of the different vapor pressures to reach the substrate.

The superiority of the present invention has been proved in the following manner.

Four glass plates A, B, C and D whose surfaces were flat and smooth were prepared. Polycrystalline silicon films 5,000 Å thick were formed on the respective glass substrates by the MBE method. Subsequently, only the glass plate B was formed with an $SiO_2$ film of a thickness of 2,000 Å by the MBE method (Sample B). Thereafter, the glass plates A - D were drawn out of the vacuum vessel. On the polycrystalline Si film of the glass plate C, an $SiO_2$ film

2,000 $\overset{\text{O}}{\text{A}}$ thick was formed by the MBE method again (Sample C). On the other hand, an $SiO_2$ film 100 $\overset{\text{O}}{\text{A}}$ thick was formed on the polycrystalline Si film of the glass plate D by the chemical vapor deposition (CVD) process (Sample D). Using the respective samples B - D, MOS type FETs were formed, and the mobilities μ were measured. The glass plate A formed with only the polycrystalline Si film was Sample A for reference.

Table 1 lists the results.

TABLE 1

| | SAMPLE | Mobility at 25$^{\text{O}}$C ($cm^2$/V·sec) | Remarks |
|---|---|---|---|
| A | poly-Si made by MBE method | $\sim$ 20 | standard sample |
| B | poly-Si made by MBE method and $SiO_2$ made by MBE method successively in the ultra high vacuum | 10 $\sim$ 20 | the present invention |
| C | poly-Si made by MBE method and $SiO_2$ made by MBE method after poly-Si was exposed to air | 2 $\sim$ 6 | comparative sample |
| D | poly-Si made by MBE method and $SiO_2$ made by CVD method | 1 $\sim$ 5 | comparative sample |

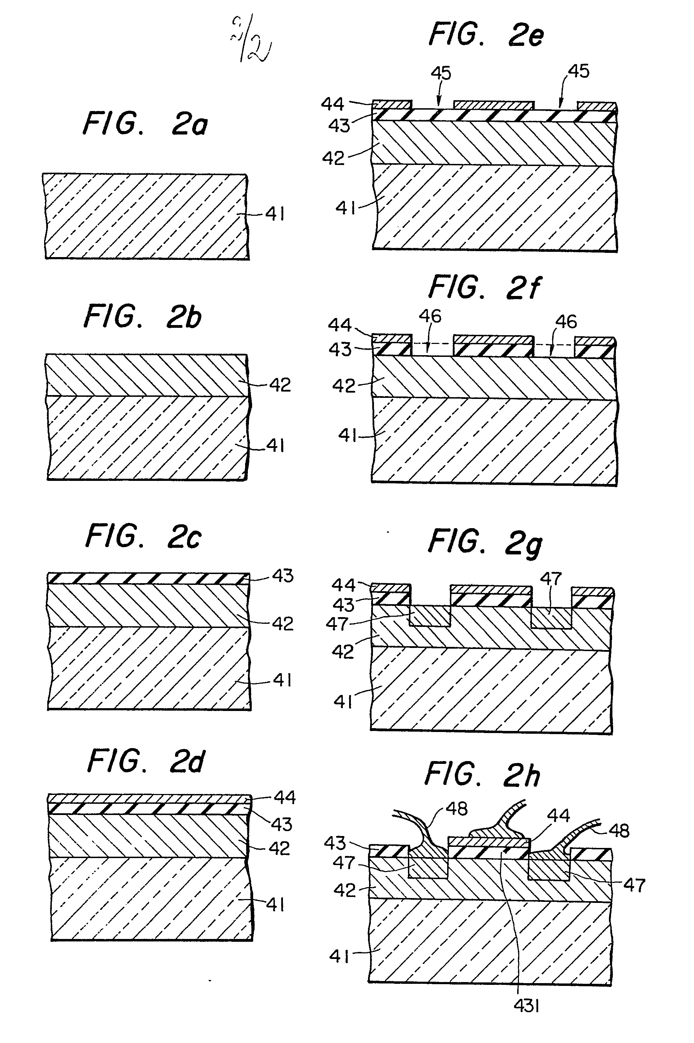

Figures 2a - 2h are schematic flow diagrams of a semiconductor device which was formed by the use of the present invention.

As shown in Figure 2a, a transparent glass substrate 41 was prepared. Subsequently, as shown in Figure 2b, an Si thin layer 42 having a thickness of 500 $\overset{\text{o}}{\text{A}}$ to several μm is formed on the substrate 41, by heating a first evaporation source (an Si bar) with an electron beam by the ultra-high vacuum evaporation apparatus described before. Usually, the Si thin layer becomes polycrystalline. An Si molecular beam vaporised from the molecular beam source employing an electron gun is deposited within the ultra-high vacuum atmosphere which has a base vacuum degree of at most $10^{-9}$ Torr. In this case, the substrate 41 is held at 500°C (usually, at 400 - 650°C). In forming the Si thin layer 42, a molecular beam of an impurity controlled to be n-conductivity type or p-conductivity type, for example Sb or Ga, is evaporated simultaneously with the Si. Usually, a doping source for the impurity doping is packed in another crucible and is heated for the doping separately from the Si source. Subsequently, as shown in Figure 2c, an $SiO_2$ film 43 is vacuum-evaporated on the Si thin layer 42 in the ultra-high vacuum atmosphere. The oxide film 43 suffices with a thickness of about 0.3 μm. Subsequently, as shown in Figure 2d, a Mo film 44 is formed on the oxide film 43 by vacuum evaporation within the ultra-high vacuum atmosphere. As the evaporation source of the Mo film, a Mo piece is inserted in a crucible in advance. It is melted by a heating method utilizing induction heating, an electron beam or the like. Further, high-melting metals such as Ni, W, Ti, Cr, Pd and Pt can be similarly used. Of course, metal elements or alloys of comparatively low melting points, such as Au and Al, may be similarly employed. In this case, the crucible may be at a comparatively low temperature, e.g. heated by electric resistance heating. In this manner, the films of the semiconductor, insulator and metal which have properties different from one another are successively stacked on the glass substrate, whereupon the resultant structure is taken out of the ultra-high vacuum vessel so as to form a semiconductor device by the conventional semiconductor element-producing technology. More specifically, as shown in Figure 2e and Figure 2f, using the known lithography technique, windows 45 for diffusing a conductivity type impurity are formed in the Mo film 44, and windows 46 are subsequently formed in the oxide film 43 by utilizing the windows 45. When employing ion implantation for the introduction of an impurity, the metal film 44 serves as an implantation mask, and hence, the oxide film 43 may well remain in the implantation windows. When employing thermal diffusion, diffusion windows 46 extending down to the Si film 42 are, of course, used. At the next step, as shown in Figure 2g, diffusion regions 47 of a p-conductivity type impurity are formed in the Si thin layer 42 through the implantation windows. As to the conditions of the ion implantation, by way of example, boron is turned into cations, which are implanted at an acceleration voltage of 200 keV and at a dose of about $3 \times 10^{15}/cm^2$. After the ion implantation, the resultant structure is annealed at $500^{O}C$ for about 1 hour, to complete the conductive regions. Of course, the conductive regions may be similarly formed by conventional thermal diffusion. The conductive regions 47 formed function as the source and drain regions of the MOS transistor. After the unnecessary parts of the metal film 44 have been removed, metal electrodes 48 of Al are formed by conventional vacuum evaporation or the like as shown in Figure 2h. External.lead wires are connected to the metal electrodes. Then, the MOS transistor is completed. Although, in the Figure, the device is depicted as a discrete component element provided with lead wires, it is needless to say that in the case of an IC etc., the electrodes are connected by stripe-shaped metal films.

A gate oxide film 431 formed by this method is very clean, and the transistor manufactured by the above steps exhibits good characteristics. This is because, during the ion implantation, the metal film 44 prevents the ions from being introduced into the oxide film 43. Such effect does not depend upon the sort of the metal. Similar effects are achieved even with the various metals mentioned previously. Owing to the effect, no defect which gives rise to a surface state which lowers the mobility of the transistor is observed in the gate oxide film 431. Thus, the mobility of the polycrystalline silicon film-transistor has been improved by a factor of two or more. Naturally, the prior-art step of removing contaminated oxide films together after the ion implantation is dispensed with, so that the process for forming a device is remarkably simplified. Furthermore, the metal film 44 can be used as an electrode as it is, and this point is greatly advantageous in the process. In this manner, where the ion implantation step of doping a semiconductor with a high level of impurity atoms is used and where a metal mask is required, the present invention is very effective for preventing a predetermined region such as a channel region from being contaminated due to the impurity doping.

The example described above in detail has a great industrial merit in that in forming multilayer films by continuously evaporating a semiconductor film, insulating film, metal film etc. on a predetermined substrate within an ultra-high vacuum vessel, the interfaces of the films can be made clean.

While only the manufacture of a MOSFET has been referred to in the foregoing embodiment, one skilled in the art will be able to readily conjecture that the present invention is easily applicable to any other active or passive element or an element having a plurality of thin layers such as multilayer interconnection layers and passivation layers.

In the above embodiment, Si has been exemplified as a semiconductor material. Even when other semiconductor materials, for example, Ge or a compound semiconductor such as GaAs and GaAlAs are used, quite similar effects are achieved. That is, the interfaces of the layers of the various materials are very good. In addition, where an impurity is ion-implanted into a material layer underlying a metal layer through an opening provided in the metal layer, there is the advantage that the impurity can be introduced locally into the part corresponding to the opening, without being mixed into unnecessary parts.

CLAIMS

1.  A method of manufacturing a semiconductor device, including the step of evacuating a vacuum vessel (11) to an ultra-high vacuum, the vessel containing a first evaporation source (124) and a substrate (13;41) having a surface onto which a layer is to be evaporated; and the step of forming a first evaporation layer (42) on said surface using the first evaporation source; characterised in that the vacuum vessel contains at least a second evaporation source (12), and the method includes the step of subsequently forming a second evaporation layer (43) on the first evaporation layer, using the second evaporation source, without removing the substrate from the vacuum vessel between the formation of the first and second evaporation layers.

2.  A method of manufacturing a semiconductor device according to claim 1 wherein one of the evaporation sources (124) is a semiconductor material, and another evaporation source (12) is an insulator material.

3.  A method of manufacturing a semiconductor device according to claim 1 or claim 2 wherein the pressure of the ultra-high vacuum is at most $10^{-9}$ Torr.

4.  A method of manufacturing a semiconductor device according to any one of the preceding claims, including the step of forming one or more further evaporation layers (44) over the second evaporation layer without removing the substrate from the vacuum vessel.

5.  A method of manufacturing a semiconductor device according to claim 4, wherein at least three evaporation sources (124,12,12',12",121) are used, a semiconductor layer (42) is formed on the substrate, an insulator layer (43) and a metal layer (44) are thereafter formed on said semiconductor layer, these steps being carried out without taking the resultant substrate out of the vacuum vessel, holes (45,46) are formed in at least said metal layer, and an impurity is introduced into at least said semiconductor layer through said metal layer.

6. A method of manufacturing a semiconductor device according to any one of the preceding claims, wherein said substrate (13) is an amorphous substrate or a polycrystalline substrate.

7. A method of manufacturing a semiconductor device according to any one of the preceding claims, wherein the temperature of the substrate is between room temperature and the softening temperature thereof.

FIG. 1

1/2

0056737

2/2

## FIG. 2e

44
43
42
45    45
41

## FIG. 2a

41

## FIG. 2f

44
43
42    46    46
41

## FIG. 2b

42
41

## FIG. 2g

44
43
47
42    47
41

## FIG. 2c

43
42
41

## FIG. 2d

44
43
42
41

## FIG. 2h

43    48    44    48
47    47
42
41
431